# EUROPEAN PATENT SPECIFICATION

(11) **EP 0 347 878 B1**
(45) Date of publication and mention of the grant of the patent: **07.09.1994**
(21) Application number: 89111292.2
(22) Date of filing: 21.06.1989
(51) Int. Cl.: C08G 69/00

(54) **Method for manufacturing polyamide resin**
Verfahren zur Herstellung von Polyamidharz
Procédé pour la production de résine polyamide

(30) Priority: 22.06.1988 JP 152243/88
(43) Date of publication of application: 27.12.1989
(73) Proprietor: Tosoh Corporation, Shinnanyo-shi Yamaguchi-ken (JP)
(72) Inventor: Imai, Yoshio, Tokyo (JP); Kakimoto, Masa-aki, Yokohama-shi Kanagawa-ken (JP); Yoneyama, Masaru, Tokyo (JP); Tanaka, Masanori, Tokyo (JP)
(74) Representative: VOSSIUS & PARTNER

(56) References cited:
- DE-A- 1 945 704
- US-A- 4 093 677
- US-A- 4 595 745

## Description

The present invention relates to a method for manufacturing a polyamide resin which contains double bonds in its main chain.

Polyamide resins having double bonds in the main chain have been used as industrial materials because of their excellent photosensitivity. A method for manufacturing the resins has been known in which a diamine and an alkenoic dichloride are made to undergo polycondensation in an organic solvent.

The method of the prior art involves problems such that the synthesis is extremely laborious because of the instability of the alkenoic dichloride and the troublesomeness in handling thereof, thus causing disadvantage of difficulty and high cost in manufacturing polyamide resins having double bonds in the main chain.

It is the object of the present invention to provide a method for manufacturing a polyamide resin having double bonds in its main chain that starts from materials which are stable, easy to handle, and inexpensive. The aforementioned problems could surprisingly be solved according to the present invention by the use of a bis-alkenoic amide.

The present invention relates to a method for manufacturing a polyamide resin having double bonds in its main chain, comprising a repeating unit represented by the formula (I):

[-Ar¹-CR¹=CR²-CO-NR³-R⁴-NR³-CO-CR²=CR¹-] (I)

wherein Ar¹ is a bivalent aromatic radical, each of R¹, R² and R³ represents independently a hydrogen atom or a univalent aromatic or aliphatic radical, R⁴ is a bivalent aromatic or aliphatic radical, and having a reduced viscosity (ηsp/c) of 0.1 - 5.0 dl/g at a concentration of 0.5 g/dl in N,N-dimethylacetamide at 30°C, characterized in that a bis-alkenoic amide represented by the general formula (II):

CHR¹=CR²-CO-NR³-R⁴-NR³-CO-CR²=CHR¹ (II)

wherein R¹, R², R³ and R⁴ are defined as above is reacted with an aromatic dihalide represented by the general formula (III):

X-Ar¹-X (III)

wherein Ar¹ is defined as above and X is a halogen atom, in the presence of a palladium catalyst in an amount ranging from 0.01 to 10% relative to the bis-alkenoic amide and the aromatic dihalide and a base present in an amount ranging from 2 to 5 equiv. to the aromatic dihalide in an organic solvent and within a temperature range of 50 to 250°C.

The bis-alkenoic amide represented by the general formula (II) can be prepared easily by linking 2 mols of alkenoic chloride and 1 mol of a diamine. In the formula, each of R¹, R² and R³ represents independently a hydrogen atom, an aryl radical (preferably C₆-C₁₀) such as phenyl, tolyl, anisyl and nitrophenyl, or an aliphatic radical such as C₁-C₈ alkyl. R¹ and R² and/or R¹ and R³ may be linked together to form a ring structure.

R⁴ is a bivalent aromatic radical shown below (preferably C₆-C₁₅) or a bivalent aliphatic radical such as C₁-C₁₅ alkylene. The aliphatic radical may be of a branched structure or of an alicyclic ring structure. 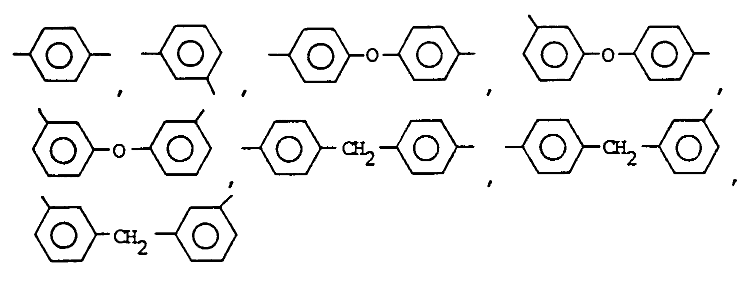
Bis-alkenoic amides wherein the bridging unit (R⁴) is not a bivalent aromatic radical but a alkenyl radical are disclosed in US-A-4093677.

The typical aromatic dihalides represented by the general formula (III) include m-dibromobenzene, p-dibromobenzene, 3,3'-dibromodiphenylmethane, 4,4'-dibromodiphenylmethane, 3,4'-dibromodiphenylmethane, 3,3'-dibromodiphenyl ether, 4,4'-dibromodiphenyl ether, 3,4'-dibromodiphenyl ether, 2,5-dibromothiophene, 2,5-bis(4-bromophenyl)-3,4-diphenylthiophene, m-diiodobenzene, p-diiodobenzene, 3,3'-diiododiphenylmethane, 4,4'-diiododiphenylmethane, 3,4'-diiododiphenylmethane, 3,3'-diiododiphenyl ether, 4,4'-diiododiphenyl ether, 3,4′-diiododiphenyl ether, 2,5-diiodothiophene and 2,5-bis(4-iodophenyl)-3,4-diphenylthiophene.

The bases include inorganic bases such as sodium hydroxide, potassium hydroxide, sodium carbonate, potassium carbonate, sodium hydrogencarbonate, potassium hydrogencarbonate, sodium acetate, and potassium acetate, and organic bases such as tributylamine, 4-dimethylaminopyridine,
1,8-diazabicyclo[5,4,0]undecene-7,
1,5-diazabicyclo[4,3,0]nonene-5, and
1,4-diazabicyclo[2,2,2]octane.

The organic solvents include amide type solvents such as N,N-dimethylformamide, N,N-dimethylacetamide, N-methyl-2-pyrrolidone, tetramethylurea, and hexamethylphosphoramide; aromatic solvents such as benzene, toluene, xylene, nitrobenzene and benzonitrile; and ether type solvents such as dibutyl ether, tetrahydrofuran, dioxane and di(methoxyethyl) ether; and dimethyl sulfoxide and pyridine.

The exemplified palladium catalysts include halides, organic acid salts and inorganic acid salts of palladium: specifically, palladium acetate, palladium chloride, palladium bromide, palladium iodide, palladium sulfate, and complexes of the aforementioned palladium compounds with phosphine compounds such as dichloro-bis(triphenylphosphine) palladium, dibromo-bis(triphenylphosphine) palladium, diiodo-bis(triphenylphosphine) palladium, dichloro-bis(tritolylphosphine) palladium, dibromo-bis(tritolylphosphine) palladium, diiodo-bis(tritolylphosphine) palladium, chlorophenyl-bis(triphenylphosphine) palladium, bromophenyl-bis(triphenylphosphine) palladium, tetrakis(triphenylphosphine) palladium, and dichloro-bis(benzonitrile) palladium. The amount of the palladium catalyst employed ranges from 0.01 to 10 %, preferably from 0.1 to 5 % relative to the bis-alkenoic amide and the aromatic dihalide. Addition of triphenylphosphine to the reaction mixture (prior to heat) often gives a more favorable result.

The amount of the base employed ranges from 2 to 5 equiv. to the aromatic dihalide, preferably 2.5 to 3 equiv.

The reaction temperature is within the range of from 50 to 250°C, preferably from 80 to 200°C.

The present invention will be explained in detail by employing working examples.

### Example 1:

1.055 g (2.5 mmols) of N,N'-bis-acryloyl-3,4-diaminodiphenyl ether, 0.770 g (2.5 mmols) of 4,4'-diiododiphenyl ether, 0.0056 g (0.025 mmol) of palladium acetate, 0.030 g (0.1 mmol) of tritolylphosphine, and 0.533 g (6.5 mmols) of sodium acetate were dissolved in 10 ml of N,N-dimethylformamide, and agitated for 4 hours at 100°C under nitrogen stream. After completion of the reaction, the reaction mixture was poured into 500 ml of methanol to yield the polyamide, and it was dried in vacuo.
Yield: 1.185 g (100 %)
Reduced viscosity: 0.84 dl/g (at a concentration of 0.5 g/dl in N,N-dimethylacetamide at 30°C)
The IR spectrum had a characteristic absorption of amide at 3300 cm⁻¹, absorption of carbonyl at 1660 cm⁻¹, and absorption of carbon-carbon double bonds at 1630 cm⁻¹.

### Example 2:

The polyamide prepared in Example 1 was dissolved in N,N-dimethylacetamide, and was flow-casted on a glass plate to form a film. Approximately half of the area of the film was covered with an aluminum foil, and the whole film was exposed to irradiation from a 400-W high pressure mercury lamp about 20 cm apart therefrom for 30 minutes. The aluminum foil was removed and then the whole film was immersed in N,N-dimethylformamide to find that the portion having been covered with the aluminum foil was soluble in N,N-dimethylformamide, but the portion not having been covered with the aluminum foil was insoluble therein.

The present invention has made it possible to manufacture a polyamide resin having double bonds in the main chain by a simpler process at a lower cost with a higher yield than conventional processes.

## Claims

1. A method for manufacturing a polyamide resin having double bonds in its main chain, comprising a repeating unit represented by the formula (I):
[-Ar¹-CR¹=CR²-CO-NR³-R⁴-NR³-CO-CR²=CR¹-] (I)
wherein Ar¹ is a bivalent aromatic radical, each of R¹, R² and R³ represents independently a hydrogen atom or a univalent aromatic or aliphatic radical, R⁴ is a bivalent aromatic or aliphatic radical, and having a reduced viscosity (ηsp/c) of 0.1 - 5.0 dl/g at a concentration of 0.5 g/dl in N,N-dimethylacetamide at 30°C, characterized in that
a bis-alkenoic amide of the general formula (II):
CHR¹=CR²-CO-NR³-R⁴-NR³-CO-CR²=CHR¹ (II)
wherein R¹, R² and R³ are defined as above is reacted with an aromatic dihalide represented by the general formula (III):
X-Ar¹-X (III)
wherein Ar¹ is defined as above and X is a halogen atom, in the presence of a palladium catalyst in an amount ranging from 0.01 to 10% relative to the bis-alkenoic amide and the aromatic dihalide and a base present in an amount ranging from 2 to 5 equiv. to the aromatic dihalide in an organic solvent and within a temperature range of 50 to 250°C.

2. A method according to claim 1, wherein the aromatic dihalide is m-dibromobenzene, p-dibromobenzene, 3,3'-dibromodiphenylmethane, 3,4'-dibromodiphenylmethane, 4,4'-dibromodiphenylmethane, 3,4'-dibromodiphenyl ether, 4,4'-dibromodiphenyl ether, 2,5-dibromothiophene or 2,5-bis(4-bromophenyl)-3,4-diphenylthiophene.

3. A method according to claim 1, wherein the organic solvent is an aprotic solvent such as N,N-dimethylformamide, N,N-dimethylacetamide, dimethyl sulfoxide and pyridine.

4. A method according to claim 1, wherein the palladium catalyst is palladium acetate, palladium chloride, dichloro-bis(triphenylphosphine) palladium, tetrakis(triphenylphosphine) palladium, or dichloro-bis(benzonitrile) palladium.

5. A method according to claim 1, wherein said base is a tertiary amine such as 1,4-diazabicyclo[2,2,2]octane, 4-dimethylaminopyridine and 1,8-diazabicyclo[5,4,0]undecene-7.

## Patentansprüche

1. Verfahren zur Herstellung eines Polyamidharzes mit Doppelbindungen in der Hauptkette, umfassend eine dich wiederholende Einheit, die durch die Formel (I) wiedergegeben wird:
[-Ar¹-CR¹=CR²-CO-NR³-R⁴-NR³-CO-CR²=CR¹-] (I)
in der Ar¹ einen zweiwertigen aromatischen Rest darstellt, jeder der Reste R¹, R² und R³ unabhängig ein Wasserstoffatom oder einen einwertigen aromatischen oder aliphatischen Rest bedeutet, R⁴ einen zweiwertigen aromatischen oder aliphatischen Rest darstellt, das eine reduzierte Viskosität (ηsp/c) von 0,1 - 5,0 dl/g bei einer Konzentration von 0,5 g/dl in N,N-Dimethylacetamid bei 30°C aufweist, gekennzeichnet dadurch, daß ein Bisalkenamid, wiedergegeben durch die allgemeine Formel (II):
CHR¹=CR²-CO-NR³-R⁴-NR³-CO-CR²=CHR¹ (II)
in der R¹, R² und R³ wie vorstehend definiert sind, mit einem aromatischen Dihalogenid, wiedergegeben durch die allgemeine Formel (III):
X-Ar¹-X (III)
in der Ar¹ wie vorstehend definiert ist und X ein Halogenatom bedeutet, in Gegenwart eines Palladiumkatalysators in einer Menge von 0,01 bis 10%, bezogen auf das Bisalkenamid und das aromatische Dihalogenid, und einer Base, anwesend in einer Menge von 2 bis 5 Äquivalenten, bezogen auf das aromatische Dihalogenid, in einem aromatischen Lösungsmittel in einem Temperaturbereich von 50 bis 250°C, umgesetzt wird.

2. Verfahren nach Anspruch 1, in der das aromatische Dihalogenid m-Dibrombenzol, p-Dibrombenzol, 3,3 -Dibromdiphenylmethan, 3,4 -Dibromdiphenylmethan, 4,4 -Dibromdiphenylmethan, 3,4 -Dibromdiphenyläther, 4,4 -Dibromdiphenyläther, 2,5-Dibromthiophen oder 2,5-Bis(4-bromphenyl)-3,4-diphenylthiophen ist.

3. Verfahren nach Anspruch 1, in dem das organische Lösungsmittel ein aprotisches Lösungsmittel, wie N,N-Dimethylformamid, N,N-Dimethylacetamid, Dimethylsulfoxid und Pyridin ist.

4. Verfahren nach Anspruch 1, in dem der Palladiumkatalysator Palladiumacetat, Palladiumchlorid, Dichlorbis(triphenylphosphin)palladium, Tetrakis(triphenylphosphin)palladium oder Dichlor-bis(benzonitril)palladium ist.

5. Verfahren nach Anspruch 1, in dem die Base ein tertiäres Amin, wie 1,4-Diazabicyclo[2,2,2]octan, 4-Dimethylaminopyridin und 1,8-Diazabicyclo[5,4,0]undezen-7 ist.

## Revendications

1. Procédé pour fabriquer une résine de polyamide ayant des liaisons doubles dans sa chaîne principale, comprenant un motif représenté par la formule (I) :
[-Ar¹-CR¹=CR²-CO-NR³-R⁴-NR³-CO-CR²=CR¹-] (I)
dans laquelle Ar¹ est un radical aromatique bivalent, chacun des R¹, R² et R³ représente indépendamment un atome d'hydrogène ou un radical aromatique ou aliphatique univalent, R⁴ est un radical aromatique ou aliphatique bivalent, et ayant une viscosité réduite (ηsp/c) de 0,1-5,0 dl/g à une concentration de 0,5 g/dl dans du N,N-diméthylacétamide à 30°C, caractérisé en ce que
un amide bis-alcénoïque de la formule générale (II) :
CHR¹=CR²-CO-NR³-R⁴-NR³-CO-CR²=CHR¹ (II)
dans laquelle R¹, R², et R³ sont tels que définis ci-dessus, est mis à réagir avec un dihalogénure aromatique représenté par la formule générale (III) :
X-Ar¹-X (III)
dans laquelle Ar¹ est tel que défini ci-dessus et X est un atome d'halogène, en présence d'un catalyseur de palladium dans une quantité comprise entre 0,01 et 10 % par rapport à l'amide bis-alcénoïque et au dihalogénure aromatique et d'une base présente dans une quantité comprise entre 2 et 5 équivalents au dihalogénure aromatique dans un solvant organique et dans une gamme de température de 50 à 250°C.

2. Procédé selon la revendication 1, dans lequel le dihalogénure aromatique est le : m-dibromobenzène, p-dibromobenzène, 3,3'-dibromodiphénylméthane, 3,4'-dibromodiphénylméthane, 4,4'-dibromodiphénylméthane, éther 3,4'-dibromodiphénylique, éther 4,4'-dibromodiphénylique, 2,5-dibromothiophène ou 2,5-bis(4-bromophényl)-3,4-diphénylthiophène.

3. Procédé selon la revendication 1, dans lequel le solvant organique est un solvant aprotique tel que : N,N-diméthylformamide, N,N-diméthylacétamide, sulfoxyde de diméthyle et pyridine.

4. Procédé selon la revendication 1, dans lequel le catalyseur de palladium est : acétate de palladium, chlorure de palladium, dichlorobis(triphénylphosphine) palladium, tétrakis(triphénylphosphine) palladium ou dichlorobis(benzonitrile) palladium.

5. Procédé selon la revendication 1, dans lequel ladite base est une amine tertiaire telle que : 1,4-diazabicyclo[2,2,2]octane, 4-diméthylaminopyridine et 1,8-diazabicyclo[5,4,O]undécène-7.
